# EUROPÄISCHE PATENTANMELDUNG

(11) **EP 2 743 973 A2**
(43) Veröffentlichungstag der Anmeldung: **18.06.2014**
(21) Anmeldenummer: 13193456.4
(22) Anmeldetag: 19.11.2013
(51) Int. Cl.: H01L 21/60, H01L 23/488, H01L 23/49

(54) **Verfahren zur Kontaktierung eines Halbleiterelements mittels Schweißens eines Kontaktelements an eine Sinterschicht auf dem Halbleiterelement und Halbleiterbauelement mit erhöhter Stabilität gegenüber thermomechanischen Einflüssen**

(30) Priorität: 11.12.2012 DE 102012222791
(71) Anmelder: ROBERT BOSCH GMBH, 70442 Stuttgart (DE)
(72) Erfinder: Guenther, Michael, 70469 Stuttgart (DE)

(57) **Zusammenfassung**

Die vorliegende Erfindung betrifft ein Verfahren zur elektrischen Kontaktierung eines Halbleiterelements (1) als erstem Fügepartner mit einem Kontaktelement (7) als zweitem Fügepartner mit den Schritten: A) Aufbringen eines Sinterwerkstoffs zur Ausbildung einer schweißbaren Sinterschicht (2) auf eine Oberseite des Halbleiterelements (1), B) im Wesentlichen druckfreies Sintern unter Ausbildung einer schweißbaren Sinterschicht (2) auf der Oberseite des Halbleiterelements (1), C) Bestücken der ausgebildeten Sinterschicht (2) mit dem Kontaktelement (7), D) im Wesentlichen druckfreie Ausbildung eines Stoffschlusses und der elektrischen Kontaktierung zwischen der Oberseite des Halbleiterelements (1) und dem Kontaktelement (7) mittels Schweißens, insbesondere mittels Laserschweißens.

Die Schritte B) und C) können in beliebiger Reihenfolge durchgeführt werden.

Die Erfindung betrifft weiterhin ein Halbleiterbauelement (10) hergestellt nach dem erfindungsgemäßen Verfahren.

## Beschreibung

Die vorliegende Erfindung betrifft Verfahren zur Kontaktierung eines Halbleiters gemäß dem Oberbegriff des Anspruchs 1, sowie ein Halbleiterbauelement gemäß dem Oberbegriff des Anspruchs 9.

### Stand der Technik

Halbleiter werden für Anwendungen mit einem geringen lateralen Platzangebot direkt auf einem Schaltungsträger montiert, um eine elektrische Funktionalität abzubilden. Die Montage erfolgt üblicherweise durch Löten oder Kleben. Zur Kontaktierung der Oberfläche des Halbleiters, beispielsweise Dioden, MOSFET (metal oxide semiconductor field-effect transistor), IGBT (insulated-gate bipolar transistor), wird üblicherweise die Drahtbondtechnik bzw. Bändchenbondtechnik eingesetzt. Dabei wird eine stoffschlüssige Verbindung zwischen der Oberseite des Halbleiters und einem Draht oder Bändchen, beispielsweise aus Aluminium, hergestellt. Das Ende des Drahtes bzw. Bändchens wird an einer zweiten Fügestelle wiederum mit dem Schaltungsträger verbunden, um die gleiche Verdrahtungsebene zu erreichen. Durch Zuverlässigkeitstests wird die Robustheit elektrischer Schaltungen abgeprüft. Ein typisches und lebensdauerbegrenzendes Ausfallbild ist hierbei das Versagen der Verbindungsstelle von Draht oder Bändchen und Halbleiter. Das Versagen ist oftmals darin begründet, dass der thermische Ausdehnungskoeffizient von dem in der Regel verwendeten Aluminium als Draht oder Bändchen bei 23 µm/m·K und der von dem Halbleitermaterial Silizium bei ca. 2 µm/m·K liegt. Auch bei anderen Metallen, die als Bonddraht oder -Bändchen oder Bleche zur elektrischen Kontaktierung verwendet werden, wie beispielsweise Kupfer oder Gold, ist dieses Problem gegeben. Im thermomechanischen Wechselspiel tritt daher eine Zerrüttung der Fügestelle von Aluminium und Silizium oder der darauf aufgebrachten Metallisierung auf, die wiederum eine Erhöhung des elektrischen Widerstandes zur Folge hat. Durch die lokale Widerstandserhöhung treten, insbesondere bei hohen Strömen in Leistungsschaltungen, Verlustleistungen auf, die eine lokale Temperaturerhöhung und somit eine Zerstörung der Anbindung zur Folge haben. Weiterhin kommt es durch die üblicherweise vorhandene dünne Metallisierung auf den Halbleitern zu sehr hohen Stromdichten in der Metallisierung selbst und an der Verbindungsstelle von Chipmetallisierung und Bonddraht.

Die Druckschrift DE 10 2006 013 336 A1 beschreibt ein Kontaktierungsverfahren für Halbleitermaterial sowie ein Halbleiterbauelement mit einer in der Oberfläche des Halbleiters angeordneten elektrischen Kontakt zwischen dem Halbleitermaterial und einer Metallisierung vermittelnden Diffusionsbarriere. Die Diffusionsbarriere wird dabei durch eine auf wenigstens einem Teil der Halbleiteroberfläche aufgebrachte und eingesinterte metallhaltige Paste ausgebildet.

In der Offenlegungsschrift DE 10 2009 045 181 A1 sind Leistungshalbleitermodule beschrieben, in denen ein erster und ein zweiter Leistungshalbleiterchip jeweils eine obere und eine untere Chipmetallisierung aufweisen. Es wird beschrieben, dass der erste Leistungshalbleiterchip über die obere und/oder untere Metallisierung an jeweils eines der folgenden Verbindungsmittel unmittelbar angrenzt: eine Schmelzlotschicht oder ein Aluminiumbasierter Bonddraht. Es ist weiterhin beschrieben, dass die Chipmetallisierungen des zweiten Leistungshalbleiters an jeweils eines der folgenden zweiten Verbindungsmittel unmittelbar angrenzt: eine Diffusionslotschicht, eine silberhaltige Sinterschicht, eine Klebeschicht oder ein kupferbasierter Bonddraht. Die Herstellung einer beispielsweise ein Keramiksubstrat und den Leistungshalbleiterchip verbindenden silberhaltigen Sinterschicht erfolgt mittels Niedertemperatur-Drucksintern.

Die Offenlegungsschrift DE 10 2005 058 794 A1 beschreibt eine Vorrichtung und ein getaktetes Verfahren zur Drucksinterverbindung in einer Mehrzahl von chipförmigen Bauelementen mit Leiterbahnen eines Substrats. Die Vorrichtung weist eine Pressvorrichtung mit einem Presstisch und einem Pressstempel, ein Transportband und eine weitere Vorrichtung zur Abdeckung des Substrats mit einer Schutzfolie auf. Die Oberseite des Substrats mit den darauf angeordneten chipförmigen Bauelementen wird mit der Schutzfolie bedeckt und anschließend die Drucksinterverbindung zwischen den Bauelementen und dem Substrat und dessen Leiterbahnen hergestellt.

### Offenbarung der Erfindung

Gegenstand der vorliegenden Erfindung ist ein Verfahren zur elektrischen Kontaktierung eines Halbleiters als erstem Fügepartner mit einem Kontaktelement als zweitem Fügepartner, umfassend folgende Schritte
A) Aufbringen eines Sinterwerkstoffs zur Ausbildung einer schweißbaren Sinterschicht auf eine Oberseite des Halbleiters,
B) im Wesentlichen druckfreies Sintern unter Ausbildung einer schweißbaren Sinterschicht auf der Oberseite des Halbleiters,
C) Bestücken der ausgebildeten Sinterschicht mit dem Kontaktelement,
D) im Wesentlichen druckfreie Ausbildung eines Stoffschlusses und der elektrischen Kontaktierung zwischen der Oberseite des Halbleiters und dem Kontaktelement.

Unter Halbleitern werden erfindungsgemäß konventionelle Halbleiter, insbesondere Leistungshalbleiter, beispielsweise Dioden, MOSFETs (metal oxide semiconductor field effect transistor), IGBT (insulated-gate bipolar transistor), oder dergleichen verstanden. Die Halbleiter weisen mindestens eine zu kontaktierende Funktionsoberfläche auf, die in der Regel zumindest teilweise mit einer Metallisierung versehen ist. Die Metallisierung kann beispielsweise eine kupferbasierte oder aluminiumbasierte Chipmetallisierung sein. Es ist möglich, dass die Chipmetallisierung weitere funktionelle Beschichtungen, beispielsweise Edelmetallkaschierungen oder Oxidschichten trägt. Die zu kontaktierende funktionelle Oberfläche des Halbleiters wird erfindungsgemäß als Oberseite bezeichnet.

Kontaktelemente im Sinne der Erfindung sind beispielsweise, Bonddrähte, Bondbändchen, Litzen, oder Bleche zur elektrischen Kontaktierung. Erfindungsgemäß wird das Kontaktelement in Schritt C) in einem Verbindungsbereich auf die Sinterschicht beispielsweise aufgelegt, gegebenenfalls zumindest temporär aufgeklebt, und nachfolgend im Schritt D) in dem Verbindungsbereich mit dem Halbleiter stoffschlüssig verbunden und elektrisch kontaktiert. Der Stoffschluss erfolgt in die Sinterschicht hinein. Ein zweiter Verbindungsbereich des Kontaktelements steht zur weiteren Kontaktierung mit einem weiteren Fügepartner, beispielsweise mit einem Schaltungsträger, zur Verfügung. Es ist selbstverständlich möglich eines oder auch mehrere Kontaktelemente im erfindungsgemäßen Verfahren einzusetzen und mit einem Halbleiter zu kontaktieren.

Unter dem Merkmal "im Wesentlichen druckfrei" wird erfindungsgemäß verstanden, dass, insbesondere die Verfahrensschritte B) und D) vorzugsweise ohne druckunterstützte Prozesse, beispielsweise ohne Pressen oder Stempeln, und im Wesentlichen ohne Druckbeaufschlagung ausgeführt werden. Erfindungsgemäß können die Verfahrensschritte B) und D) mit einem Prozessdruck von maximal 10 MPa, insbesondere unterhalb von 1 MPa beispielsweise unterhalb von 0,5 MPa ausgeführt werden.

Erfindungsgemäß wird ein Verfahren zur Kontaktierung bereitgestellt, mit dem ein druckunterstützter Sinterprozess zur elektrischen und mechanischen Anbindung eines Kontaktelements ersetzt werden kann und der auf die Oberseite des Halbleiters aufgebrachte Sinterwerkstoff offen, idealerweise ohne Druckbeaufschlagung, gegebenenfalls getrocknet, und zu einer Sinterschicht unter üblicher Wärmeeinwirkung (gewöhnlich kleiner 300 °C) versintert wird. Der Füge- und Verbindungsprozess mit dem Kontaktelement zur elektrischen Kontaktierung kann unabhängig, idealerweise ebenfalls im Wesentlichen ohne Ausübung von Druck erfolgen. Durch diese erfindungsgemäße Vorgehensweise ist es möglich die mechanische Belastung des Halbleiters deutlich herabzusetzen und hierdurch verursachte Chipbrüche (Halbleiterbrüche) zu vermeiden.

Mit dem erfindungsgemäßen Verfahren ist es weiterhin möglich einen stabilen Oberseitenkontakt eines Halbleiters bereit zu stellen, der gegenüber einer thermomechanischen Belastung stabiler ist. Dies ist insbesondere durch die Aufbringung der Sinterschicht auf die zu kontaktierende Funktionsoberfläche des Halbleiters möglich, die sandwichartig eine Zwischenschicht zwischen der Oberseite des Halbleiters und dem zu kontaktierenden Teil des Kontaktelements (Verbindungsbereich) bildet. Die erfindungsgemäße Sinterschicht wirkt, insbesondere bei erhöhter Temperatur, plastisch und damit spannungsabbauend. Durch hohe Temperaturwechselbelastung verursachte Ausfälle können auf diese Weise vermieden oder zumindest reduziert werden. Das erfindungsgemäße Verfahren ermöglicht somit der lebensdauerbegrenzende Zerrüttung der elektrischen Kontaktierung, wie sie beispielsweise bei üblichen Bondverbindungen auftritt, entgegenzuwirken. Die erfindungsgemäß mögliche Erhöhung der Qualität der Kontaktierung kommt insbesondere bei schnell schaltenden Leistungshalbleiterchips zum Tragen, die bei hoher Temperatur und mit hoher Temperaturwechselbelastung betrieben werden. Deren Lebensdauer und die der damit hergestellten Elektronikbauteile kann erheblich verlängert werden.

Die ausgebildete Sinterschicht aus schweißbarem Material trägt zusätzlich zur Schonung des Halbleiters während der Kontaktierung bei, in dem die Durchführung der elektrischen Anbindung an das Kontaktelement, beispielsweise mit einem Schweißprozess möglich wird, was sonst beispielweise aufgrund der Metallisierung auf der Oberseite nicht möglich wäre.

Der in Schritt A) aufgebrachte Sinterwerkstoff wird auch als Depot bezeichnet. Die Aufbringung kann beispielsweise durch etablierte Druckprozesse, wie Sieboder Schablonendruck oder durch Dispensen erfolgen.

Im Rahmen eines erfindungsgemäßen Verfahrens ist es auch möglich, dass das Sintern des Sinterwerkstoffs zur Sinterschicht in Schritt B) erst nach dem Auflegen des Kontaktelements auf die dann noch nicht gesinterte Sinterschicht, (also Schritt C vor Schritt B) erfolgt. In diesem Fall wird dann beispielsweise das Depot aus Silbersinterpaste mit einem ersten Verbindungsbereich eines Kontaktelements oder auch mehrerer Kontaktelemente belegt und dann im Wesentlichen druckfrei als Verbund mit der Oberseite des Halbleiters versintert. Hierbei spielt es erfindungsgemäß keine Rolle, ob das aufgelegte Kontaktelement mit der Sinterschicht versintert oder überhaupt, aufgrund der Materialwahl oder einer vorhandenen Oberflächenmetallisierung des Kontaktelements, in der Lage ist versintert zu werden, da es nur um die Ausbildung der Form der Sinterschicht geht und der Stoffschluss und die elektrische Kontaktierung mit dem Halbleiter als Fügepartner in einem separaten Schritt D) erfolgt.

Im Rahmen einer Ausführungsform ist vorgesehen, dass die Ausbildung des Stoffschlusses und elektrischen Kontaktierung in Schritt D) mittels Schweißen, insbesondere mittels Laserschweißen, erfolgt. Durch die Verschweißung kann ein stabiler Oberseitenkontakt eines Halbleiters ohne oder mit nur geringster Druckbeaufschlagung und damit vergleichsweise materialschonend hergestellt werden. Die Laserstrahlung wird beim Kontaktierschritt D) so eingestellt, dass der Stoffschluss und damit die elektrische Kontaktierung bewirkt werden, wobei jedoch kein vollständiges Aufschmelzen der Sinterschicht durch die Laserstrahlung, insbesondere in Richtung des Halbleiters, erfolgt. Somit wird eine direkte Wechselwirkung der Halbleiteroberfläche mit der Laserstrahlung vermieden. Da der Stoffschluss durch Schweißen erfolgt, können hierdurch bei den Fügepartnern, insbesondere dem Kontaktelement beispielsweise Materialien, wie Kupfer oder Silber eingesetzt werden, die im Hinblick auf den Halbleiter einen besser angepassten thermischen Ausdehnungskoeffizienten aufweisen. Insbesondere können auch Materialien für das Kontaktelement eingesetzt werden, die nicht ansinterbar sind, wie Aluminium, Eisen, Titan oder MMC (Metal Matrix Composite) und/oder einen besser angepassten thermischen Ausdehnungskoeffizienten oder im Falle der MMC gegebenenfalls ein speziell designtes thermisches Ausdehnungsverhalten aufweisen. Die Materialauswahl wird erfindungsgemäß somit deutlich erweitert und ermöglicht, neben der besseren Abstimmung der Materialien der Fügepartner auch eine verbesserte Anpassung auf die angestrebte Anwendung des Halbleiterbauelements. Die Kontaktelemente können zudem eine oder mehrere Oberflächenmetallisierungen, beispielsweise aus Kupfer, Silber oder Gold aufweisen. Des Weiteren ermöglicht die Verschweißung, insbesondere das Laserschweißen, die elektrische Kontaktierung im Wesentlichen ohne Druckbeaufschlagung auszubilden. Auf diese Weise kann die mechanische Belastung des erfindungsgemäß hergestellten Halbleiterbauelements reduziert und beispielsweise daraus folgende Chipbrüche (Halbleiterbrüche) vermieden werden.

Der Einsatz eines Laserschweißvorgangs zur Herstellung des Stoffschlusses in Schritt D) hat gegenüber anderen Schweißverfahren den Vorteil eines geringen, konzentrierten Wärmeeintrags zum Halbleiter und somit eine besonders geringem thermischen Verzug. Das Laserschweißen ist auch durch die extrem kurze Schweißzeit nochmals materialschonender und es lassen sich dauerhaft sichere und reproduzierbare stoffschlüssige Verbindungen und damit zuverlässige elektrische Kontaktierungen von Halbleitern herstellen.

Im Rahmen einer weiteren Ausführungsform handelt es sich bei dem in Schritt A) eingesetzten Sinterwerkstoff mit metallischen Sinterpartikeln beispielsweise um eine Sinterpaste oder einen Pulverwerkstoff enthaltend größer gleich 75 Gew.-% Silber oder einer Silberlegierung bezogen auf das Gesamtgewicht des Sinterwerkstoffs. Dieses Silbersintermaterial kann weiterhin mit metallischen und/oder keramischen Hilfspartikel mit einem Gesamtgewichtsanteil (metallische und keramische Hilfsstoffe) von kleiner gleich 25 Gew.-% bis größer gleich 0 Gew.-% bezogen auf das Gesamtgewicht des Sinterwerkstoffs gefüllt sein. Die Materialien für die metallischen Hilfsstoffe können insbesondere ausgewählt sein aus Silizium, Nickel, Kupfer, Zink, Zinn, Mangan, Molybdän, Wolfram, Aluminium, Titan, Tantal oder Legierungen hieraus. Grundsätzlich eignen sich als Metallpartikel in den Sinterwerkstoffen Flakes oder Pulver mit Partikelgrößen im µm-Bereich.
Für die keramischen Hilfspartikel können insbesondere Materialien wie Aluminiumoxid (auch dotiert), Aluminiumnitrid, Berylliumoxid und Siliziumnitrid eingesetzt werden, die die Wärmeleitfähigkeit der Hilfspartikel gewährleisten. Als Hilfspartikel können aber auch solche aus elektrisch leitfähigen Keramiken wie Borkarbid oder Siliziumkarbid eingesetzt werden. Die Hilfspartikel können jeweils aus den genannten Materialien bestehen oder daraus ausgebildet sein.

Die Silber- oder Silberlegierungssinterpasten umfassen gewöhnlich Silberpulver und/oder eine Silberlegierung in Pulverform und ein Lösungsmittel, beispielsweise ein organisches Lösungsmittel, zur Gewährleistung der pastösen Eigenschaften. Die erfindungsgemäß eingesetzten Silbersinterpasten enthalten darüber hinaus ein oder mehrere metallische oder keramische Hilfsstoffe, wie vorstehend beschrieben, die auch als Füllstoffe bezeichnet werden. Organische Hilfsstoffe können beispielsweise als Druckhilfsstoffe zur Einstellung der Viskosität in die Sinterpasten eingebracht werden, beispielsweise können die Silber- oder Silberlegierungspartikel mit einer organischen Beschichtung versehen sein.

Ebenso ist eine Ausführungsform realisierbar, in der der Sinterwerkstoff als Sintermaterialvorform (Preform), also bereits als Formkörper beispielweise aus den genannten Materialien ausgebildet ist.

Im Rahmen einer weiteren Ausführungsform ist vorgesehen, dass das Aufbringen des Sinterwerkstoffs in einer Schichtdicke erfolgt, dass mindestens zwischen der Oberseite des Halbleiters und dem Kontaktelement die Sinterschicht in einer Schichtdicke von größer gleich 10 µm bis kleiner gleich 1 mm, insbesondere größer gleich 25 µm bis kleiner gleich 500 µm, beispielsweise größer gleich 50 µm bis kleiner gleich 200 µm ausgebildet wird.

Im Rahmen einer weiteren Ausführungsform ist vorgesehen, dass der Sinterwerkstoff in Schritt A) durch einen Druckprozess, wie Siebdruck, Stempeldruck, Rollendruck, Schablonendruck, oder in einem Dispens- oder Inkjetverfahren appliziert oder durch Auflegen einer Sintermaterialvorform (Preform) auf die Oberseite des Halbleiters aufgebracht wird. Es ist also vorteilhafterweise erfindungsgemäß möglich, für diesen Schritt aufwandsgünstige und etablierte Techniken und Prozesse einzusetzen, die auch für die Serienfertigung geeignet sind.

Im Rahmen einer weiteren Ausführungsform ist vorgesehen, dass das Kontaktelement, aus einem Material ausgewählt aus der Gruppe Kupfer, Silber, Gold, Aluminium, Eisen, Titan, oder einer Legierung der genannten Metalle oder aus MMC (Metal Matrix Composite), besteht oder daraus ausgebildet ist. Vorteilhafterweise können hierbei auch Materialien eingesetzt werden, bei denen eine Anbindung mittels einer Sinterschicht, beispielsweise in einem Drucksinterprozess, nicht möglich ist, da erfindungsgemäß der Stoffschluss in einem separaten Schritt, insbesondere durch Schweißen erfolgt. Werden zwei oder mehr Kontaktelemente eingesetzt, können diese aus gleichen oder unterschiedlichen Materialien ausgebildet sein.

Im Rahmen einer weiteren Ausführungsform wird vor dem Schritt A) der Halbleiter auf einem Schaltungsträger als drittem Fügepartner aufgebracht. Mit anderen Worten wird in Schritt A) des Verfahrens ein bereits auf einem Trägersubstrat, insbesondere Schaltungsträger, gefügter oder montierter Halbleiter eingesetzt. Auf diese Weise wird eine Stabilisierung der Halbleiter erreicht und es können, insbesondere bei dünnen Halbleitern, Verbiegungen bei einseitiger Weiterverarbeitung vermieden werden.

Im Rahmen einer Ausführungsform, in der der Halbleiter auf einem Schaltungsträger als drittem Fügepartner aufgebracht ist, ist vorgesehen, dass das Kontaktelement oder die Kontaktelemente mit einem noch nicht kontaktierten Ende, auch Verbindungsbereich genannt in einem Schritt E) mit einem Leiterbereich des Schaltungsträgers, elektrisch kontaktiert wird. Unter einem Leiterbereich wird eine übliche oberflächliche Metallisierung auf einem Träger, wie einem Keramiksubstrat, beispielsweise in Form von Leiterbahnen, Leiterflächen oder Pads verstanden.

In einer Ausgestaltung der vorstehend beschriebenen Ausführungsformen, umfassend einen Schaltungsträger als Fügepartner, ist vorgesehen, dass das Kontaktelement in Schritt E) mit einem Leiterbereich des Schaltungsträgers, druckfrei, insbesondere durch Schweißen, elektrisch kontaktiert wird. Der Stoffschluss kann beispielsweise durch Setzen von Schweißpunkten oder Schweißflächen, insbesondere mittels Laserschweißen erfolgen. Vorteilhafterweise kann die elektrische Anbindung an den dritten Fügepartner ebenfalls im Wesentlichen ohne druckunterstützten Prozessschritt erfolgen und somit die mechanische Belastung des ausgebildeten Halbleiterelements vermieden oder zumindest reduziert werden.

Gegenstand der Erfindung ist weiterhin ein Halbleiterbauelement, welches mindestens einen Halbleiter und ein damit elektrisch kontaktiertes Kontaktelement umfasst, insbesondere hergestellt nach einem erfindungsgemäßen Verfahren, wie es vorstehend in verschiedenen Ausgestaltungen beschrieben wurde, wobei erfindungsgemäß zwischen einer Oberseite des Halbleiters und einem ersten Verbindungsbereich des Kontaktelements eine schweißbare Sinterschicht ausgebildet ist, und weiterhin das Kontaktelement durch Schweißpunkte durch die Sinterschicht mit dem Halbleiter stoffschlüssig verbunden und elektrisch kontaktiert ist und das Kontaktelement mit einem zweiten Verbindungsbereich zur weiteren elektrischen Kontaktierung zur Verfügung steht.

Im Rahmen einer Ausführungsform des erfindungsgemäßen Halbleiterbauelement ist vorgesehen, dass die Sinterschicht eine Silbersinterschicht enthaltend größer gleich 75 Gew.-% an Silber oder einer Silberlegierung bezogen auf das Gesamtgewicht der Sinterschicht, sowie ein oder mehrere metallische und/oder keramische Hilfsstoffe in Form von Partikeln mit einem Anteil größer gleich 25 Gew.% und kleiner gleich 0 Gew.-%. Die Sinterschicht ist thermisch und elektrisch leitend.
Die Metalle für die metallischen Hilfspartikel können insbesondere ausgewählt sein aus Silizium, Nickel, Kupfer, Zink, Zinn, Mangan, Molybdän, Wolfram, Aluminium, Titan, Tantal oder Legierungen hieraus. Für die keramischen Hilfspartikel können insbesondere Materialien wie Aluminiumoxid (auch dotiert), Aluminiumnitrid, Berylliumoxid und Siliziumnitrid eingesetzt werden, die die Wärmeleitfähigkeit der Hilfspartikel gewährleisten. Als Hilfspartikel können aber auch elektrisch leitfähige Keramiken Borkarbid oder Siliziumkarbid eingesetzt werden.

Halbleiter in den erfindungsgemäßen Halbleiterbauelementen sind insbesondere Leistungshalbleiter, insbesondere für das Steuern und Schalten hoher elektrischer Ströme und Spannungen, beispielsweise Dioden, MOSFETs (metal oxide semiconductor field effect transistor), IGBT (insulated-gate bipolar transistor) oder dergleichen, da vorteilhafterweise hierbei lokale Widerstandserhöhungen durch schadhafte Kontaktierungen sicher und dauerhaft vermieden werden können, die ansonsten bei hohen Strömen leicht zu Ausfällen führen können.

Das erfindungsgemäße Halbleiterbauelement kann einen Halbleiter aufweisen, der auf einem elektrischen Schaltungsträger, beispielsweise einem PCB (Printed Circuit Board), einem DCB-Substrat (Direct Copper bonded), einem AMB-Substrat, einem LTCC-Substrat, oder einem Stanzgitter angeordnet und kontaktiert ist, wobei für diese Anbindung eine konventionelle Fügeschicht Verwendung finden kann. Als Fügeschicht kann beispielsweise ein Lot, ein Leitkleber oder eine Sinterschicht vorgesehen sein. Ist der Halbleiter auf einem Schaltungsträger angeordnet, wird die dem Schaltungsträger entgegengesetzte Oberfläche des Halbleiters erfindungsgemäß als Oberseite bezeichnet.

Auf einer, erfindungsgemäß als Oberseite bezeichneten Seite des Halbleiters, besteht die Kontaktierung des Halbleiters zu einem Kontaktelement unter Verwendung einer Sinterschicht als Zwischenschicht. Die Kontaktierung kann insbesondere gemäß dem erfindungsgemäßen Verfahren hergestellt oder ausgestaltet sein. Die Sinterschicht zwischen der Halbleiteroberfläche und dem Kontaktelement ist demnach erfindungsgemäß idealerweise offen und ohne druckunterstützten Sinterprozess ausgebildet. Die auf dem Halbleiter aufgebrachte Sinterschicht wirkt erfindungsgemäß bei erhöhter Temperatur plastisch, uns wirkt somit vorteilhafterweise spannungsabbauend und einer Zerrüttung der Verbindung und elektrischen Kontaktierung zwischen Halbleiter und Kontaktelement entgegen.

Das erfindungsgemäße Verfahren und nach dem erfindungemäßen Verfahren hergestellte Halbleiterbauelemente können bei Produkten eingesetzt werden, bei denen eine elektrische Verbindung zu elektrischen Bauelementen hergestellt werden muss. Auf Lotverbindungen, die gegebenenfalls bleihaltige Verbindungen enthalten, kann hierbei vorteilhafterweise verzichtet werden und durch die erfindungemäß im Wesentlichen druckfrei, also ohne Verwendung von druckunterstützten Prozessen oder Prozessen mit nur geringer Druckbeaufschlagung hergestellte elektrische Verbindungen ersetzt werden. Bisher auftretende Lebensdauerbeschränkungen können, wie vorstehend bereits beschrieben überwunden werden.

Beispiele für Anwendungen und Einsatzgebiete der Erfindung sind: Wechselrichter, Gleichrichter, Leistungshalbleiter, Leistungsendstufen und Motorsteuerungen sowie Solarzellen beziehungsweise die Kontaktierung von Solarzellen. Beispielsweise Leistungsendstufen von elektrischen Servolenkungen, Leistungsendstufen von universellen Wechselrichteinheiten, Regelelektroniken, insbesondere am Starter und/oder Generator, Einpressdioden an Generatorschilden, hochtemperaturstabile Halbleitern, wie Silliziumkarbid, oder Sensoren, die unter hoher Temperatur betrieben werden, sowie Module für Wechselrichter an Photovoltaikanlagen. Diese Aufzählung ist nicht abschließend zu verstehen. Weitere Anwendungen sind ebenfalls möglich.

Hinsichtlich weiterer Vorteile und Merkmale wird hiermit explizit auf die Erläuterungen im Zusammenhang mit dem erfindungsgemäßen Verfahren sowie den Figuren verwiesen. Auch sollen erfindungsgemäße Merkmale und Vorteile des erfindungsgemäßen Halbleiterbauelements auch für das erfindungsgemäße Verfahren anwendbar sein und als offenbart gelten und umgekehrt. Unter die Erfindung fallen auch sämtliche Kombinationen aus zumindest zwei von in der Beschreibung, den Ansprüchen und/oder in den Figuren offenbarten Merkmalen.

### Figuren und Beispiele

Weitere Vorteile und vorteilhafte Ausgestaltungen der erfindungsgemäßen Gegenstände werden durch die Figuren veranschaulicht und in der nachfolgenden Beschreibung erläutert. Dabei ist zu beachten, dass die Figuren nur beschreibenden Charakter haben und nicht dazu gedacht sind, die Erfindung in irgendeiner Form einzuschränken.

In den Figuren sind gleiche Elemente und Elemente mit der gleichen Funktion mit den gleichen Bezugszeichen gekennzeichnet

Es zeigen
- Fig. 1: eine schematische Schnittansicht eines Halbleiters mit aufgebrachter Sinterschicht auf einem Schaltungsträger;
- Fig. 2: eine schematische Schnittansicht eines Halbleiters aus Fig. 1 mit aufgelegtem Kontaktelement;
- Fig. 3: eine schematische
- Fig. 4: eine schematische Draufsicht auf eine Ausgestaltung des erfindungsgemäßen Halbleiterbauelements;
- Fig. 5: eine Draufsicht auf eine alternative Ausgestaltung des erfindungsgemäßen Halbleiterbauelements.

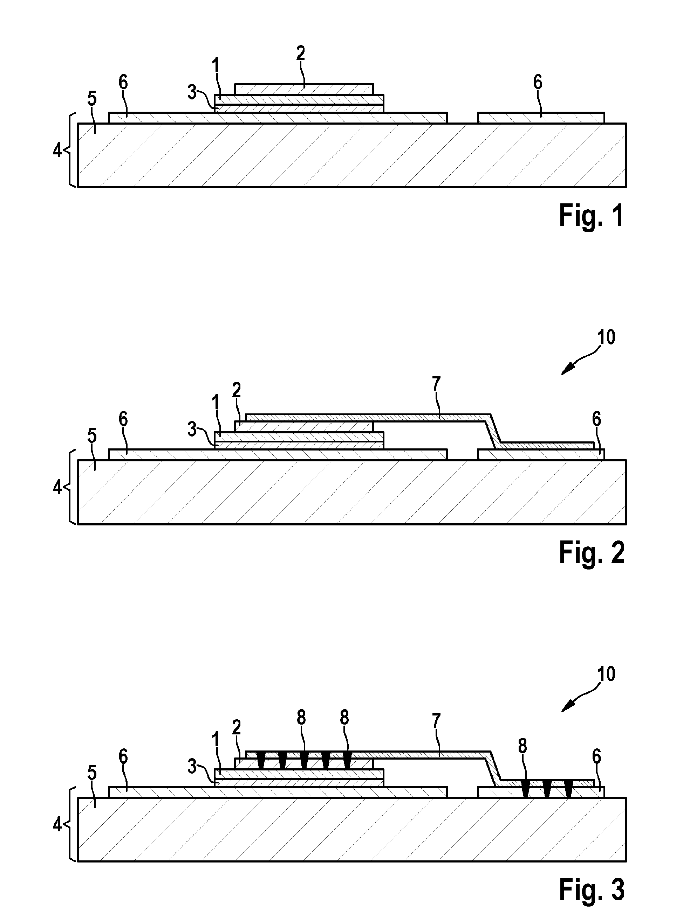

Figur 1 zeigt in einer schematischen Schnittansicht einen Halbleiter 1, der bereits über eine Fügeschicht 3, auf einem Schaltungsträger 4, umfassend ein Substrat 5 und Leiterbereiche 6, gefügt ist. Die Fügeschicht 3 kann eine übliche Fügeschicht, beispielsweise eine Lotschicht oder eine Sinterschicht sein. Der Schaltungsträger 4 umfasst als Leiterbereiche 6, beispielsweise Metallisierungen in Form von Leiterbahnen, Leiterflächen oder Pads. Im Schritt A) des findungsgemäßen Verfahrens wurde ein Depot an Sinterwerkstoff zur Ausbildung einer schweißbaren Sinterschicht 2 auf die dem Schaltungsträger 4 entgegen gesetzte Oberseite des Halbleiters 1 aufgebracht. Der Sinterwerkstoff kann insbesondere ein Silbersintermaterial sein oder dieses enthalten. Die Aufbringung des Sinterwerkstoffs kann insbesondere durch einen Druckprozess, beispielsweise mit Hilfe einer Stufenschablone oder in einem Dispens- oder Inkjetverfahren erfolgen. Alternativ kann auch eine Preform aus sinterfähigem Material aufgelegt werden. Durch die vorherige Anordnung des Halbleiters 1 auf einem Schaltungsträger 4 wird der Halbleiter gestützt und es können vorteilhafterweise Verbiegungen, insbesondere von dünnen Halbleitern, vermieden werden. Zusätzlich müssen erfindungsgemäß keine dicken, aufwändigen und kostenintensiven Metallisierungen zur elektrischen Kontaktierung auf dem Halbleiter vorgesehen werden.

Figur 2 zeigt in einer schematischen Schnittansicht die Ausgestaltung aus Figur 1 in der auf die aufgebrachte, gegebenenfalls gesinterte, Sinterschicht 2 auf dem Halbleiter 1 ein Kontaktelement 7 mit einem Endstück, beispielsweise ein Bonddraht oder Bondbändchen, auf die Sinterschicht 2 angeordnet ist. Mit einem zweiten Endstück, auch Verbindungsbereich genannt, ist das Kontaktelement mit einem Leiterbereich 6, beispielsweise einer Metallisierung, beispielsweise in Form einer Leiterbahn 6 des Schaltungsträgers 4 aufgelegt. Erfindungsgemäß kann das Sintern des Sinterwerkstoffs zur Sinterschicht 2 vor oder nach dem Bestücken mit dem des Kontaktelements 7, beispielsweise durch Auflegen des Kontaktelements 7, erfolgen. Vorteilhafterweise spielt es erfindungsgemäß dabei keine Rolle, ob das Kontaktelement 7 aus einem sinterbaren Material ausgebildet ist, da der Stoffschluss zur elektrischen Kontaktierung in einem separaten Schritt D) erfolgt. Die Materialsauswahl kann erfindungsgemäß so deutlich erweitert und vorteilhafterweise auf die Materialien der weiteren beteiligten Fügepartner 1, 7 und gegebenenfalls auf bestimmte Anwendungen angepasst und abgestimmt werden, was sich vorteilhaft auf die Lebensdauer der Anbindung auswirkt.
Die auf dem Halbleiter aufgebrachte Sinterschicht 2 ist erfindungsgemäß bei erhöhter Temperatur plastisch, uns wirkt somit vorteilhafterweise spannungsabbauend und einer Zerrüttung der Verbindung und elektrischen Kontaktierung entgegen. Zudem kann sowohl der Sinterschritt B) als auch das Bestücken in Schritt C), beispielsweise durch Auflegen des Kontaktelements 7, im Wesentlichen ohne Druckbeaufschlagung, erfolgen. Die mechanische Belastung des Halbleiters 1 kann somit deutlich reduziert und hierdurch verursachte Chipbrüche vermieden werden. Es ist selbstverständlich möglich mehr als ein Kontaktelement 7 nach dem erfindungsgemäßen Verfahren mit einem Halbleiter 1 elektrisch und mechanisch zu kontaktieren.

Figur 3 zeigt in einer schematischen Schnittansicht die Ausgestaltung in Figur 2 nach dem Verfahrensschritt D), nach der im Wesentlichen druckfreien Ausbildung eines Stoffschlusses und der elektrischen Kontaktierung zwischen der Oberseite des Halbleiters 1 und dem Kontaktelement 7 durch Schweißpunkte 8. Das Kontaktelement 7 ist an seinem zweiten Endstück, beispielsweise durch Schweißpunkte 8 mit Leiterbereichen 6 des Schaltungsträgers 4, elektrisch kontaktiert. Der Stoffschluss zwischen der Oberseite des Halbleiters 1 und dem Kontaktelement 7 kann vorteilhafterweise gemäß der Erfindung ebenfalls im Wesentlichen druckfrei, beispielsweise durch Laserschweißen erfolgen. Vorteilhafterweise wird in diesem erfindungsgemäßen Schritt des Verfahrens die mechanische Belastung des zu kontaktierenden Halbleiters 1 möglichst gering gehalten.

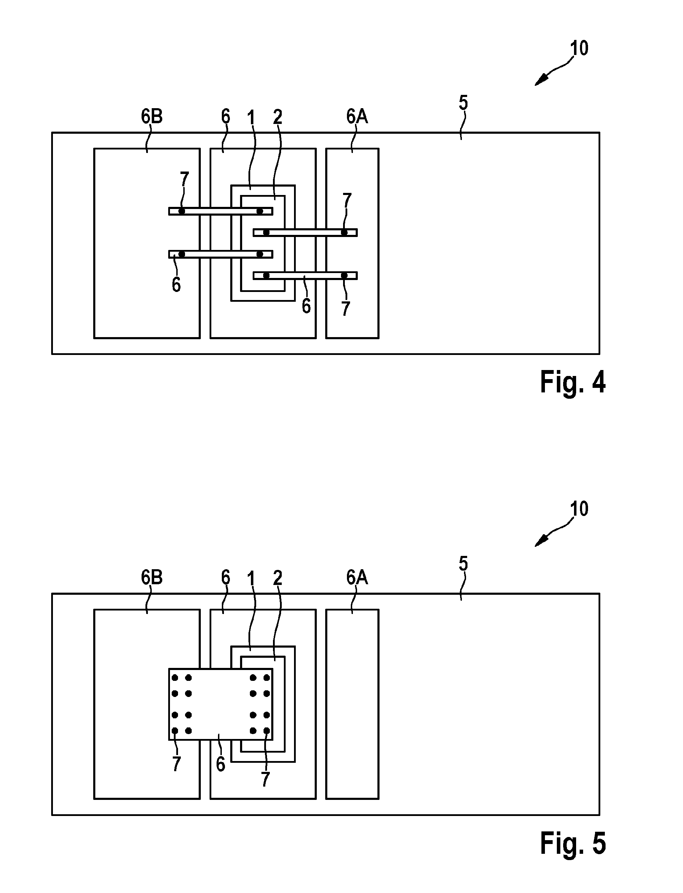

Fig. 4 zeigt eine schematische Draufsicht auf eine Ausgestaltung des erfindungsgemäßen Halbleiterbauelements 10 umfassend einen Halbleiter 1 eine darauf aufgebrachte Sinterschicht 2 und beispielhaft vier Kontaktelementen 7, die beispielsweise als Bonddrähte oder Bondbändchen ausgestaltet sein können. Der Halbleiter ist wiederum auf einen Schaltungsträger umfassend ein Substrat und beispielhaft drei Metallisierungen als Leiterbereiche 6. Die Kontaktelemente 7 sind mit dem Halbleiter 1 durch Schweißpunkte 8 elektrisch verbunden. Die Sinterschicht 2 ist sandwichartig zwischen diesen Fügepartnern 1 und 7 angeordnet. Durch die Verschweißung kann ein stabiler Oberseitenkontakt eines Halbleiters 1 hergestellt werden. Da der Stoffschluss durch Schweißen erfolgt können für die Kontaktelemente 7, auch Materialien, wie Kupfer oder Silber eingesetzt werden, die in Bezug auf den Halbleiter 1 einen besser angepassten thermischen Ausdehnungskoeffizienten aufweisen. Weiterhin können zudem Materialien für die Kontaktelemente 7 eingesetzt werden, die nicht ansinterbar sind, wie Aluminium, Eisen, Titan, Legierungen aus den genannten Metallen oder MMC (Composite) und einen besser angepassten thermischen Ausdehnungskoeffizienten oder im Falle der MMC ein speziell designtes thermisches Ausdehnungsverhalten aufweisen. Die Materialauswahl wird erfindungsgemäß somit deutlich erweitert und ermöglicht, neben der besseren Abstimmung der Materialien der Fügepartner 1 und 7 auch eine verbesserte Anpassung auf die angestrebte Anwendung des Halbleiterbauelements 10. Des Weiteren ermöglicht die Verschweißung, insbesondere das Laserschweißen, die elektrische Kontaktierung im Wesentlichen ohne mechanischen Druck auszubilden. Auf diese Weise kann die mechanische Belastung des erfindungsgemäß hergestellten Halbleiterbauelements 10 reduziert und beispielsweise daraus folgende Chipbrüche (Halbleiterbrüche) vermieden werden. Die Laserstrahlung wird beim Kontaktierschritt D) so eingestellt, dass der Stoffschluss und damit die elektrische Kontaktierung bewirkt werden, wobei kein vollständiges Aufschmelzen der Sinterschicht durch die Laserstrahlung, insbesondere in Richtung des Halbleiters (1), erfolgt. Somit wird eine direkte Wechselwirkung der Halbleiteroberfläche mit der Laserstrahlung vermieden.

Fig. 5 zeigt eine schematische Draufsicht auf eine alternative Ausgestaltung des erfindungsgemäßen Halbleiterbauelements 10 aus Fig. 4 in dem der Halbleiter 1 beispielhaft mit einem Kontaktelement 7, welches als Blech, beispielsweise als Kupferblech, durch Schweißpunkte 8 in und durch die Sinterschicht 2 elektrisch kontaktiert ist.

## Patentansprüche

1. Verfahren zur elektrischen Kontaktierung eines Halbleiters (1) als erstem Fügepartner mit einem Kontaktelement (7) als zweitem Fügepartner **gekennzeichnet durch** die Schritte
A) Aufbringen eines Sinterwerkstoffs zur Ausbildung einer schweißbaren Sinterschicht (2) auf eine Oberseite des Halbleiters (1),
B) im Wesentlichen druckfreies Sintern unter Ausbildung einer schweißbaren Sinterschicht (2) auf der Oberseite des Halbleiters (1),
C) Bestücken der ausgebildeten Sinterschicht (2) mit dem Kontaktelement (7),
D) im Wesentlichen druckfreie Ausbildung eines Stoffschlusses und der elektrischen Kontaktierung zwischen der Oberseite des Halbleiters (1) und dem Kontaktelement (7).

2. Verfahren nach Anspruch 1, **dadurch gekennzeichnet, dass** die Ausbildung des Stoffschlusses und elektrischen Kontaktierung in Schritt D) mittels Schweißen, insbesondere mittels Laserschweißen, erfolgt.

3. Verfahren nach Anspruch 1 oder 2, **dadurch gekennzeichnet, dass** als Sinterwerkstoff eine Sinterpaste, ein Pulverwerkstoff oder eine Sintervorform aus Silbersintermaterial mit einem Gewichtsanteil größer gleich 75 Gew-% Silber oder einer Silberlegierung eingesetzt wird, und gegebenenfalls metallische und/oder keramische Hilfspartikel mit einem Gesamtanteil von kleiner gleich 25 Gew.-% enthält, wobei die metallischen Hilfspartikel insbesondere ausgewählt sind aus Partikeln bestehend oder ausgebildet aus, Silizium, Nickel, Kupfer, Zink, Zinn, Mangan, Molybdän, Wolfram, Aluminium, Titan, Tantal und/oder Legierungen hieraus und/oder die keramischen Hilfspartikel, insbesondere ausgewählt sind aus Partikeln bestehend oder ausgebildet aus Aluminiumoxid, dotiertes Aluminiumoxid, Aluminiumnitrid, Berylliumoxid, Siliziumnitrid, Borkarbid und/oder Siliziumkarbid.

4. Verfahren nach einem der Ansprüche 1 bis 3, **dadurch gekennzeichnet, dass** das Aufbringen des Sinterwerkstoffs in einer Schichtdicke erfolgt, dass mindestens im Verbindungsbereich zwischen der Oberseite des Halbleiters (1) und dem Kontaktelement die Sinterschicht (2) in einer Schichtdicke von größer gleich 10 µm bis kleiner gleich 1 mm, insbesondere von größer gleich 25 µm bis kleiner gleich 500 µm, bevorzugt größer gleich 50 µm bis kleiner gleich 200 µm ausgebildet wird.

5. Verfahren nach einem der Ansprüche 1 bis 4 **dadurch gekennzeichnet, dass** der Sinterwerkstoff in Schritt A) durch einen Druckprozess oder durch Bestücken mit einer Vorform aus Sinterwerkstoff auf die Oberseite des Halbleiters (1) aufgebracht wird.

6. Verfahren nach einem der Ansprüche 1 bis 5, wobei das Kontaktelement (7) aus einem Material ausgewählt aus der Gruppe Kupfer, Silber, Gold, Aluminium, Eisen, Titan, Legierungen hieraus oder MMC, besteht oder daraus ausgebildet ist.

7. Verfahren nach einem der Ansprüche 1 bis 6, **dadurch gekennzeichnet, dass** der Halbleiter vor Schritt A) auf einem Schaltungsträger als drittem Fügepartner aufgebracht ist.

8. Verfahren nach Anspruch 7, **dadurch gekennzeichnet, dass** das Kontaktelement in einem Schritt E) mit einem Leiterbereich des Schaltungsträgers, insbesondere durch Schweißen, elektrisch kontaktiert wird.

9. Halbleiterbauelement (10) mindestens umfassend einen Halbleiter (1) und ein damit elektrisch kontaktiertes Kontaktelement (7), insbesondere hergestellt nach einem Verfahren nach einem der vorhergehenden Ansprüche 1 bis 8 **dadurch gekennzeichnet, dass** zwischen einer Oberseite des Halbleiters (1) und einem ersten Verbindungsbereich des Kontaktelements (7) eine schweißbare Sinterschicht (2) ausgebildet ist, und weiterhin das Kontaktelement (7) durch Schweißpunkte (8) oder Schweißflächen mit dem Halbleiter (1) stoffschlüssig verbunden und elektrisch kontaktiert ist und mit einem zweiten Verbindungsbereich zur weiteren elektrischen Kontaktierung zur Verfügung steht.

10. Halbleiterbauelement (10) nach Anspruch 9, **dadurch gekennzeichnet, dass** die Sinterschicht (2) eine Silbersinterschicht oder eine Sinterschicht aus einer Silberlegierung mit einem Gewichtsanteil von größer gleich 75 Gew.-% Silber oder einer Silberlegierung ist und gegebenenfalls mit einem oder mehreren metallischen und/oder keramischen Hilfspartikeln mit einem Gesamtgewichtsanteil von kleiner gleich 25 Gew.-% gefüllt ist.
